# EUROPEAN PATENT APPLICATION

(11) **EP 1 624 492 A2**
(43) Date of publication of application: **08.02.2006**
(21) Application number: 04103751.6
(22) Date of filing: 04.08.2004
(51) Int. Cl.: H01L 27/148

(54) **Virtual phase charge coupled device image sensor**

(30) Priority: 04.08.2003 US 633993
(71) Applicant: TEXAS INSTRUMENTS INCORPORATED, Dallas, TX 75265 (US)
(72) Inventor: Hynecek, Jaroslav, Allen, TX Texas 75013 (US)
(74) Representative: Holt, Michael

(57) **Abstract**

A charge coupled device (200) includes a clocked barrier pixel architecture that has a two phase gate structure and serves to substantially reduce clock-induced dark current. A first clocked gate (208) coupled to a first clocking signal input (209) forms a clocked barrier region that does not store charge. A second clocked gate (205) adjacent the first clocked gate (208) and coupled to a second clocking signal input (206) forms a clocked well region. The first clocking signal has a different potential level than the second clocking signal, and the first clocking signal is clocked in phase with the second clocking signal.

## Description

### FIELD OF THE INVENTION

The present invention relates to solid-state image sensors and specifically to a class of Virtual Phase (VP) charge coupled device (CCD) image sensors that have high sensitivity, high blue response, low smear, and that multiply collected charge using single carrier impact ionization process before charge conversion into a voltage.

### BACKGROUND OF THE INVENTION

A typical image sensor senses light by converting impinging photons into electrons that are integrated (collected) in the image sensing area array of pixels. After completion of integration collected electrons are transported into a suitable storage area by the CCD transfer process and further from the storage area into the detection node where electron charge is converted into a voltage. The resulting voltage is then supplied to the output terminals of the sensor. In Full Frame (FF) and Frame Transfer (FT) devices charge is integrated directly in the column pixels of the image area array registers and in FT devices transferred into the memory area array pixels as a block of frame data all columns in parallel. An example of the FT sensor design and operation can be found in US patent 5,430,481 to Hynecek. The FT image sensors, however, have a problem of smear. During the charge transfer process, even if the speed of the transfer is high, the transported charge data is exposed to impinging light. This causes generation and collection of unwanted charge in transported pixels that contaminates charge that is being transferred and thus creates smear. To avoid this problem Frame Interline Transfer (FIT) architecture has been developed in the past as described for example in US patent 5,442,395 to Sekiguchi. In this architecture charge is first integrated in special photo sites, which are not located directly in column registers of the image sensing area array as in the FF and FT devices. After the integration cycle is completed charge from the photo-sites is transferred into the column registers that are shielded from impinging light and then further into the storage area. Charge is thus always shielded from the impinging light during the transfer process and no significant smear is generated. The image sensors that do not have memory area and use a mechanical shutter to block off light during the readout that is performed directly from the image sensing area are called FF image sensors. All three types of the sensor architectures, FF, FT, and FIT, can be built using the VP technology. The detail description of this technology can be found in US patent 4,229,752 to Hynecek. While the VP technology has significant advantages in using fewer clock lines for charge transport and in having high Quantum Efficiency (QE), it has a problem of generating a small amount of clock induced spurious charge dark current. This becomes a disadvantage in designs that utilize charge multiplication to increase the sensor sensitivity and to reduce noise. An example of the CCD image sensor design that uses charge multiplication can be found in US patent 6,278,142 B1 and in US patent 5,337,340 both to Hynecek. The charge multiplier multiplies all charge that enters into it including the dark current and the spurious clock induced dark current. This significantly limits the sensor performance in low light level applications. While the device cooling may reduce the normal dark current generation, the spurious clock induced dark current actually increases with lowering temperature.

### SUMMARY OF THE INVENTION

It is an object of the present invention to overcome limitations in prior art. It is further object of the present invention to provide a practical image sensor design that minimizes smear and to provide architectures that significantly reduce the generation of clocking induced dark current. It is yet another object of the present invention to provide practical high performance image sensor designs with low spurious charge generation also in the serial and charge multiplication registers. Incorporating the clocked barrier pixel architecture into the image sensing area and the memory area pixels and using the two-phase gate structure accomplishes this task and other objects of the invention.

### BRIEF DESCRIPTION OF THE DRAWINGS

In the drawings:

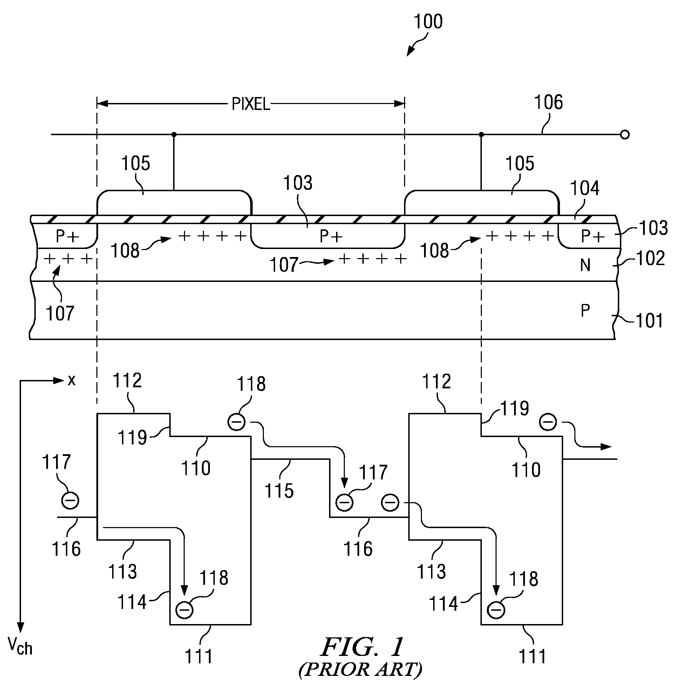

FIG. 1 is a schematic drawing of the cross section through the middle of the CCD channel of a standard prior art VP CCD device together with the corresponding channel potential profiles in the various device sections and for the high and low gate biasing levels;

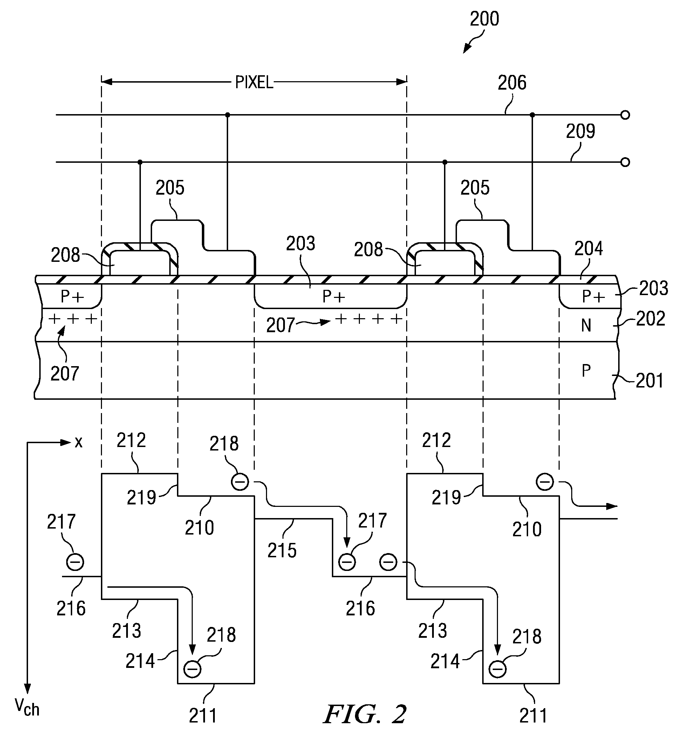

FIG.2 is a schematic drawing of the cross section through the middle of the CCD channel of a Clocked Barrier VP CCD device, according to the present invention, together with the corresponding channel potential profiles in the various device sections and for the high and low gate biasing levels;

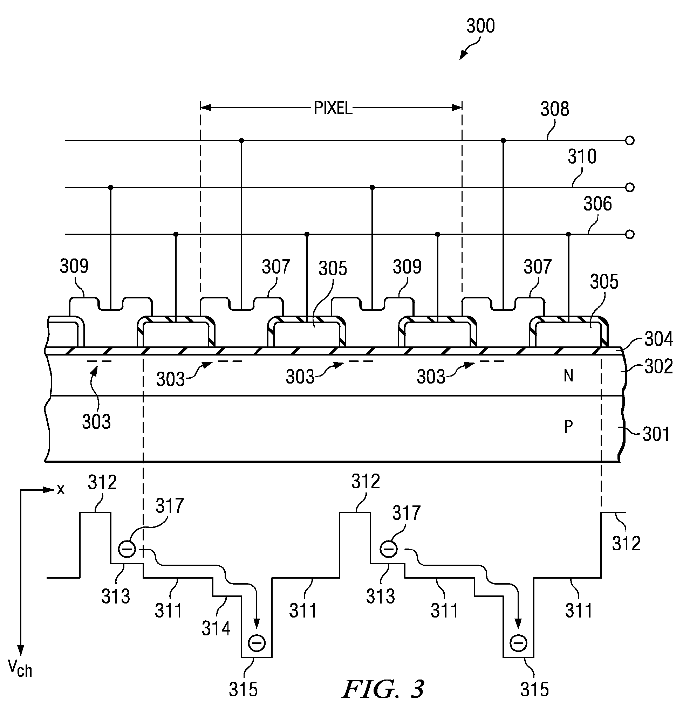

FIG. 3 is a schematic drawing of a cross section through the middle of the CCD channel of a two -phase gate structure surrounded by field plate, according to the present invention, with the corresponding potential profiles in the various device sections for one gate biased in high and the other in low biasing level.

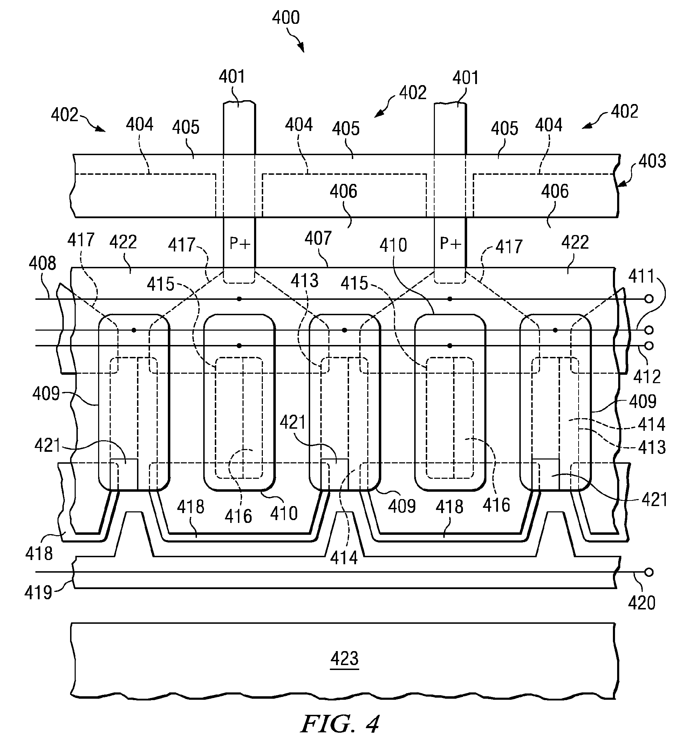

FIG. 4 is a schematic drawing of a top view of a CCD register that is using the two-phase gate structure surrounded by field plate of FIG. 3. The drawing shows the detail of the serial register that interfaces with the image storage area. The drawing also shows the detail of the charge overflow barrier and the serial register anti-blooming drain;

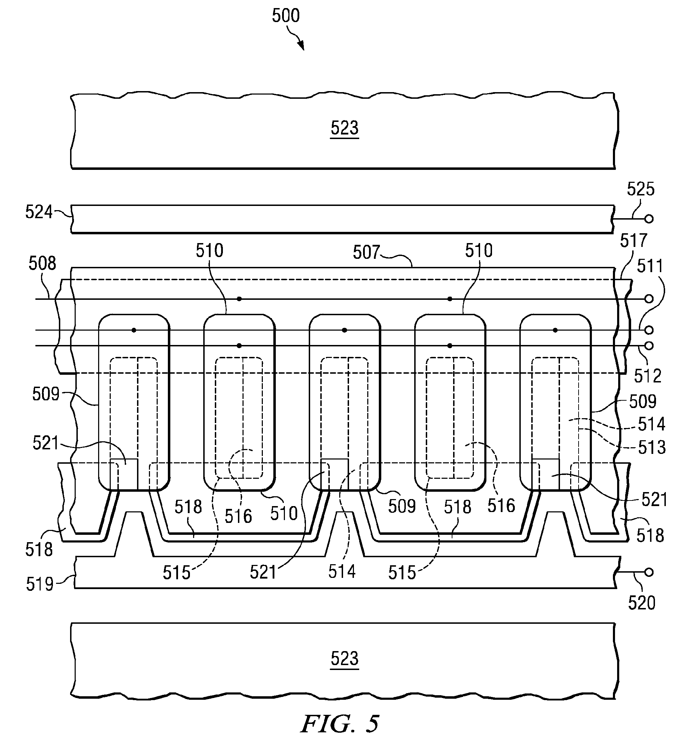

FIG. 5 is a schematic drawing of a top view of a CCD register that is using the two-phase gate structure surrounded by field plate of FIG. 3. The drawing shows the detail of the register that does not interface with the image memory area and that may also be used for charge multiplication. The drawing shows the charge overflow barrier and the serial register anti-blooming drain;

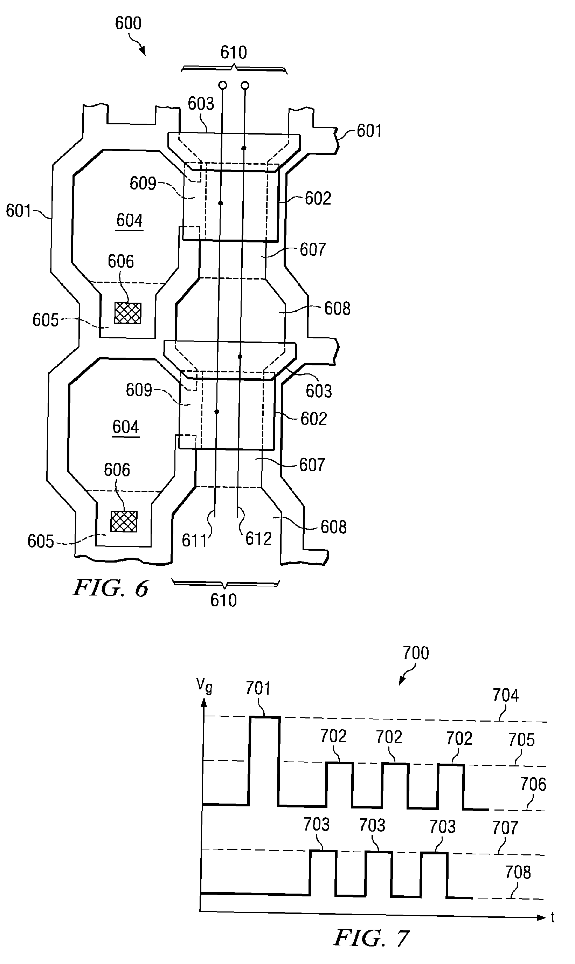

FIG. 6 is a schematic drawing of a top view of a CCD register in the image sensing area of the VP FIT CCD sensor. The drawing shows the photo-site region for collection of photo-charge, which has a lateral anti-blooming barrier with anti-blooming drain for collection of excess charge. The drawing also shows the detail of the column CCD channel that is used for fast transfer of charge into the image memory area;

FIG. 7 is a schematic drawing of a timing chart that shows the detail of the charge transfer pulse that causes transfer of collected charge from the photo-sites of the VP FIT CCD image sensor into the column registers and the subsequent pulse sequence that causes transfer of photo-charge into the image memory area.

### DETAILED DESCRIPTION OF PREFERRED EMBODIMENTS

In FIG. 1 the drawing 100 represents simplified cross section through the middle of the CCD channel of a standard prior art VP CCD device together with corresponding channel potential profiles in various device sections for the high and low gate biasing levels. P-type substrate 101 has n-type buried channel implant 102 near its surface. Oxide layer 104 separates the substrate from poly silicon gate electrodes 105 that are connected together and to a bias terminal by metal wiring 106. P+ type Virtual Phase implant 103 has been implanted between gate electrodes 105. The directionality of charge transfer is created by placing additional implants 107 and 108 near the surface of the substrate just under poly gate electrodes 105 and VP gate region 103. The resulting structure, after depletion of excess mobile charge, creates potential profile in each pixel described by segments 116, 112, 119, 110, 115, and 116, for low gate biasing level and by segments 116, 113, 114, 111, 115, and 116, for high gate biasing level. Charge packet 118, which has been stored in well 111, is transferred to level 110 when a low bias is applied to gates 105 and flows to well 116 where it becomes charge packet 117. When high bias is applied to gates 105, charge packet 117 from well 116 flows to well 111, where it becomes charge packet 118. By repeated application of high and low biases to polysilicon gates 105, charge packets are transported along the CCD register from image area pixels to the memory area pixels and from the memory area pixels through the serial register to the charge detection node for final detection and conversion to output voltage. This is well known to all those skilled in the art and will not be discussed here in any further detail. The important point to note, however, is the collapse of the well potential step 114 when the poly-silicon gate bias transitions from high to low. The step 114 is significantly reduced to a smaller step 119. The potential step reduction is advantageous for reduction of the gate clocking voltage amplitude and for improvement of Charge Transfer Efficiency (CTE). The potential step reduction is a consequence of accumulation of holes at the silicon-silicon dioxide interface under poly-silicon gates 105.
Accumulation of holes at the interface, however, has one adverse effect. When the gates transition again from low to high bias, holes escape to channel stops and to p+ regions 103 and during this process cause impact ionization. The impact ionization generates new electron-hole pairs and electrons are collected in the wells as unwanted clock induced dark current. Since both, the barrier regions 113, and the well region 111, are formed under one electrode 105, these potential levels cannot be separately controlled to avoid this problem. This is the penalty for the simplicity of VP CCD technology that requires only one gate electrode to transport charge.

It is thus desirable to design VP FF, FT, and FIT CCD image sensors, which use charge multipliers and whose pixels maintain all the advantages of the VP technology, that do not generate the spurious clocking induced dark current.

One possible solution to this problem is illustrated in drawing 200 shown in FIG. 2. In this example more complicated double layer poly-silicon gate electrodes 205 and 208 have replaced single layer poly-silicon gate electrodes 105. In drawing 200, regions 201 through 207 correspond to identical regions 101 through 107 in drawing 100. Gate electrodes 208, called Clocked Barrier electrodes, are connected together and to the bias terminal by metal wiring 209 similarly as gate electrodes 205 are connected together and to the bias terminal by metal wiring 206. Resulting potential profile that is created in silicon substrate 201 by the new poly-silicon gate structure 205 and 208 is similar to the previous potential profile shown in drawing 100. Potential profile segments and the electron charge transport shown in drawing 200 indicated by numbers 210 through 219 correspond to identical potential profile segments and the electron charge transfer indicated by numbers 110 through 119 in drawing 100. The only difference now is that potential levels 212 and 213 are controlled independently from levels 210 and 211 by applying separate and different clock biases to gates 205 and 208. The clocking bias applied to gates 205 is in phase with the clocking bias applied to gates 208. This allows the desired smaller potential step 219 without accumulation of holes. By preventing accumulation of holes at the silicon-silicon dioxide interface during clocking eliminates generation of unwanted clocking induced dark current. This significantly improves low light level performance of these devices while maintaining all other advantages of VP CCD technology. It is worth noting that the Clocked Barrier (CB) , which changes potential between levels 212 and 213, does not store charge. Charge is only quickly transferred through CB region into the neighboring well for storage. This feature is distinctly different from other similar two-poly gate structures that, however, store charge and must have adequate well capacity allocated for this purpose. The CB well capacity can be very small, since no charge is ever stored in it and the gained area can thus be allocated for the well. This preserves the charge-handling performance of VP CCD technology.

Similarly as in parallel array pixels, generation of unwanted clock induced dark current is eliminated in the sensor serial and charge multiplying register pixels by incorporating new CCD register design, whose simplified cross section is shown in drawing 300 in FIG. 3. P-type doped silicon substrate 301 has n-type doped buried layer 302 near its surface. Oxide layer 304 on top of the silicon surface separates substrate 301 from poly-silicon gates 305, 307, and 309. The first deposited layer of poly-silicon forms field plate gates 305, which are connected using metal wiring 306 to bias terminal. The second poly-silicon layer, separated form the first one by an oxide dielectric layer, forms separate and independently biased gate electrodes 307 and 309, which are also connected using respective metal wirings 308 and 310 to corresponding bias terminals. Directionality of charge transfer is established by placing suitable barrier implants 303 under a portion of each gate 307 and 309. There are other possibilities and other implant combinations that can create the desired potential profile within each pixel, which are well known to those skilled in the art, and therefore do need to be described here in any further detail. The above described gate structure, after partial depletion of mobile charge, creates potential profile in each pixel that is described by segments 314, 315, 311, 312, and 313. In this example gate 307 is biased in its high biasing level and gate 309 in its low biasing level. Circles 317 indicate the electron charge transfer within the pixel. It is important to note that field plate gate 305 is biased at a DC biasing level and is not clocked. Introducing field plate into the gate structure has two advantages. The field plate is used to create a suitable potential profile that confines charge in the direction perpendicular to the plane of the drawing without the necessity for heavily doped p+ channel stops. This eliminates the source of unwanted clocking induced dark current caused by impact ionization within such channel stops. The second advantage is a better control of potential profile when this pixel structure is used in charge multiplying registers and the charge-multiplying gate needs to be biased to high biasing levels necessary for the onset of electron multiplication.

For a better understanding of design details of the serial register of present invention, simplified drawing 400 of an example of one possible layout embodiment is shown in FIG. 4. Drawing 400 also shows the details of the interface region between the CCD memory area and serial register. The memory area consists of CCD columns separated by p+ doped channel stops 401. For simplicity only a conventional VP CCD gate structure 403 is shown with barrier region 405 and well region 404. However, the new CB VP CCD structure, shown in drawing 200, can easily be substituted here as is clear to all those skilled in the art. Gate 403 interfaces with virtual well region 402 and virtual barrier region 406 that further interfaces with field plate region 407 of the serial register. Field plate region 407, formed from the fist poly-silicon layer, has openings 415 and notches 413 that are overlaid by the second poly-silicon layer, which forms gates 409 and 410. Metal wirings 408, 411, and 412 serve as interconnects between gates, the field plate, and the biasing terminals. Charge flow directionality is established by implanting barrier regions 414 and 416 under gates 409 and 410. Charge that is transferred from memory area into the serial register flows from Virtual Barrier region 406 under field plate region 422 and further under gate 409. Charge is confined to stay in these regions by suitable potential barrier forming implants 417 and 418 that have replaced the traditional p+ channel stops used in conventional designs. It is thus apparent that gates 409 and 410, which transport charge in serial register do not overlap any p+ channel stop anywhere. This eliminates generation of spurious clocking induced dark current even for high biases required for the onset of charge multiplication. An important feature introduced in this design is the serial register blooming protection. This is accomplished by incorporating anti-blooming barrier implants 421 under gates 409. When a large amount of charge accumulates under these gates, either from excessive charge multiplication in charge multiplying sections of the register or from summing of several lines of data transferred from the memory into the register, excess charge can harmlessly overflow into drain 419 without corrupting charge signal under neighboring gates 410. Overflow charge collecting drain 419 is connected to biasing terminal by wiring 420. The drain interfaces with active device border 423. It is also apparent to those skilled in the art that it is possible to eliminate drain 419 and replace it with another complete serial register structure described above and transfer overflow charge through another charge confining region, similar to region 422, to this register. Several registers can thus be placed next to each other, their gates ganged together in parallel, and overflow charge transferred from one to the next before the final overflow charge is drained out from the structure. This design option is important for constructing devices that can handle high Dynamic Range signals.

When the serial register does not interface with the sensor imaging or memory areas, another peripheral charge collecting drain can be placed next to it. This is shown in drawing 500 in FIG. 5. In this drawing, features 507 through 523 correspond to identical features 407 through 423 shown in drawing 400. The only differences are in the shape of the charge confining potential barrier implant 517 that is now contiguous and runs continuously along the length of the register. The second difference is in elimination of region that would be equivalent to region 422. This region is not needed here, since no charge is being transferred into the serial register in parallel direction. Peripheral charge collecting drain 524 is connected to appropriate biasing terminal by wiring 525. The drain also interfaces with the border of the device active region 523.

Drawing 600 in FIG. 6 is a simplified design layout of FIT image sensing area pixel. Region 601 is the p+ type doped channel-stop that delineates the boundary of each pixel. The pixels consist of photo-site regions 604 that may be formed by n+ type doped regions or by pinned (buried) photo-diodes similar to region 103. Photo-diode 604 also interfaces with anti-blooming barrier 605 and anti-blooming drain 606. Anti-blooming barrier and drain remove excessive charge from the pixels to prevent corruption of charge data that is transported in column CCD channels 610. Metal wiring connections and contact regions to supply bias to anti-blooming drains were for simplicity omitted from the drawing. Transfer of charge from photo-diode into column channel 610 is activated when a suitable pulse is applied to gate 602. This gate may be formed from the first poly-silicon layer. The second poly-silicon layer may be used to form CB gate 603. For simplicity the gate metal interconnection wiring 611 and 612 with corresponding contact regions are shown in the drawing only schematically. Also, the photo-site light shield, which usually covers the column CCD channels, is omitted from the drawing. The virtual phase region is formed by virtual barrier region 607 and virtual well region 608. To prevent charge flow from photo-site region 604 to CCD register 610, when charge is being transported in column CCD channels 610, suitable charge transfer potential barrier forming implant 609 has been paced under poly-silicon gate 602.

The FIT sensor that uses above described pixels in its image sensing area array for charge sensing operates as follows: after completion of integrating period, collected charge from photo-sites 604 is transferred to column CCD registers 610 by using a special pulse applied to gates 602. After completion of this pulse timing interval, charge is transferred in column CCD registers 610 into the memory area array, which is adjacent to the image sensing area. The charge transfer in the columns 610 is accomplished by applying standard clocking pulses to gates 603 and 602.

To better understand the charge transfer process from photo-sites 604 and within registers 610 a simplified timing diagram 700 is shown in FIG 7. Special pulse 701 that has higher amplitude than standard, and which is being pulsed between levels 706 and 704, accomplishes the photo-site charge transfer. This pulse is applied only to gates 602. The charge transfer within registers 610 is accomplished by applying pulses 703 to gates
603 together with pulses 702 applied to gates 602. Pulses 702 and 703 have standard amplitudes and are being pulsed between levels 708 and 707 for pulses 703 and between levels 706 and 705 for pulses 702. Levels 706 and 708 may have identical bias voltages.
Levels 707 and 705 may also have identical bias voltages although different than levels 706 and 708.

The architectures of the described devices are based on the FF, FT, and on the FIT concepts. The small amount of clocked induced dark current, usually present in VP CCD devices, is eliminated in these devices by designing the CB pixel architecture for the image and memory area pixels and a special two-phase gate structure surrounded by field plate for the pixels of the serial and charge multiplication registers.

Having described preferred embodiments of novel CB FT and FIT CCD image sensors that have novel serial and charge multiplication registers with two-phase gate structure surrounded by field plate and that have significantly reduced generation of clocking induced dark current, which are intended to be illustrative and not limiting, it is noted that persons skilled in the art can make modifications and variations in light of the above teachings. It is therefore to be understood that changes may be made in the particular embodiments of the inventions disclosed, which are within the scope and spirit of the inventions as defined by appended claims.

## Claims

1. A charge coupled device comprising:
a first clocked gate for forming a clocked barrier region, and coupled to a first clocking signal, wherein the clocked barrier region does not store charge; and
a second clocked gate adjacent to the first clocked gate and coupled to a second clocking signal, the second clocked gate forms a clocked well region, wherein the first clocking signal has a different potential level than the second clocking signal, and the first clocking signal is clocked in phase with the second clocking signal.

2. The device of claim 1, wherein the first clocking signal has a lower potential level than the second clocking signal.

3. The device of either claim 1 or claim 2, further comprising a virtual gate adjacent to second clocked gate.

4. The device of claim 3, wherein the virtual gate comprises a virtual barrier and a virtual well.

5. The device of any of claims 1 - 4, wherein the second clocked gate overlaps the first clocked gate.

6. The device of any of claims 1 - 5, further comprising an insulator layer between the first clocked gate and the second clocked gate.

7. The device of any of claims 1 - 6, wherein the device is a frame transfer device.

8. The device of any of claims 1 - 7, wherein the device is a full frame device.

9. The device of any of claims 1 - 8, further comprising an antiblooming drain.

10. The device of claim 9, further comprising an antiblooming barrier adjacent the antiblooming drain.

11. The device of any preceding claim, wherein the device is a phase frame interline transfer charge coupled device, further comprising a photo-site region adjacent to the clocked well region.

12. The device of claim 11, further comprising a lateral antiblooming drain region adjacent to the photo-site region.
